(19) Europäisches Patentamt / European Patent Office / Office européen des brevets

(11) **EP 4 223 843 A1**

(12) **EUROPEAN PATENT APPLICATION**
published in accordance with Art. 153(4) EPC

(43) Date of publication:
**09.08.2023 Bulletin 2023/32**

(21) Application number: **20956263.6**

(22) Date of filing: **30.09.2020**

(51) International Patent Classification (IPC):
$C08L\ 101/00^{(2006.01)}$    $C08K\ 3/013^{(2018.01)}$
$C08K\ 3/105^{(2018.01)}$    $C08K\ 7/16^{(2006.01)}$
$C08L\ 71/00^{(2006.01)}$    $H01L\ 23/373^{(2006.01)}$

(52) Cooperative Patent Classification (CPC):
C08K 3/013; C08K 3/105; C08K 7/16; C08L 71/00;
C08L 101/00; H01L 23/373

(86) International application number:
**PCT/JP2020/037230**

(87) International publication number:
**WO 2022/070335 (07.04.2022 Gazette 2022/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Kyocera Corporation**
**Kyoto-shi Kyoto 612-8501 (JP)**

(72) Inventors:
• **GOTO, Takuma**
 **Kyoto-shi, Kyoto 612-8501 (JP)**
• **OHORI, Kazuhiko**
 **Kyoto-shi, Kyoto 612-8501 (JP)**

(74) Representative: **Viering, Jentschura & Partner mbB**
**Patent- und Rechtsanwälte**
**Am Brauhaus 8**
**01099 Dresden (DE)**

(54) **GREASE COMPOSITION AND ELECTRONIC COMPONENT USING SAME**

(57) A grease composition contains: a liquid resin (A), poly(methacrylic acid)-based organic particles (B), and an inorganic filler (C). The liquid resin (A) contains at least one type selected from the group consisting of polyols, polyethers, and diamine resins. The poly(methacrylic acid)-based organic particles (B) are dissoluble in an organic solvent having a solubility parameter (SP value) of 7.8 to 10.1.

[Fig. 1]

FIG. 1

**Description**

TECHNICAL FIELD

The present disclosure relates to a grease composition and an electronic component using the grease composition.

BACKGROUND OF INVENTION

In recent years, as electronic components have higher power and occupy smaller spaces, malfunction occurs due to heat generation of components. To release generated heat and operate components stably, each of electronic components thus employs a technique of using a heat dissipation body.

A grease composition can improve heat dissipation by interposing the grease composition between a heat generation body and a heat dissipation body. Typically, from the perspective of thermal decomposition stability, flame retardancy, and the like, known grease compositions include a thermally conductive silicone putty composition containing a silicone oil as a base and zinc oxide or alumina (e.g., Patent Document 1).

However, because an electronic component repeats heat generation and cooling, a difference in thermal expansion of a heat generation body and a heat sink is large, and occurrence of a phenomenon in which the viscosity of a grease becomes low at a high temperature and the grease is pushed out (pump-out phenomenon) has been known. In particular, recent achievement of higher power demands pump-out resistance in a 150°C region. Study of pump-out resistance in a 150°C region is not sufficient yet for silicone grease, such as the silicone grease described in Patent Document 1. Silicone grease may generate a siloxane gas when used at a high temperature. Because a siloxane gas forms silicon dioxide when attached to a point of contact with an electrode or the like, this may cause contact failure.

For example, a non-silicone thermally conductive grease composition having an improved pump-out resistance compared to silicone grease has been proposed (e.g., Patent Document 2). In these attempts, the viscosity reduction at high temperatures is reduced by blending a nonionic surfactant in a heat-resistant oil to solve the pump-out phenomenon.

CITATION LIST

PATENT LITERATURE

Patent Document 1: JP 2017-002179 A
Patent Document 2: JP 2019-089924 A

SUMMARY

PROBLEM TO BE SOLVED

However, for the non-silicone thermally conductive grease composition described in Patent Document 2, although study was conducted for pump-out resistance at 150°C up to 100 cycles but no study was conducted for pump-out resistance at 150°C up to 1000 cycles, which is required in recent years. For the grease composition, change in thermal conductivity of the thermally conductive grease composition when the thermally conductive grease composition is used for a long term is also not confirmed.

A non-silicone thermally conductive grease composition may contain a volatile component. In particular, because a nonionic surfactant, which is used as a pump-out prevention described in Patent Document 2, has a high affinity for water, moisture in the atmosphere tends to be adsorbed. When the non-silicone thermally conductive grease composition is used for a semiconductor power module or the like for an inverter frequently used outside, the non-silicone thermally conductive grease composition may readily adsorb moisture in a high humidity environment. When a temperature of a semiconductor element is increased in a moisture-adsorbed condition, a void may occur by rapid volatilization of the adsorbed moisture, and heat dissipation may deteriorate.

Accordingly, for known non-silicone thermally conductive grease compositions, studies for maintaining pump-out resistance and thermal conductivity for a long term have been insufficient.

The present disclosure provides: a grease composition reducing occurrence of pump-out at high temperatures, especially around 150°C, maintaining thermal conductivity, and reducing occurrence of a void; and an electronic component including the grease composition arranged in between a heat generation body and a heat dissipation body.

SOLUTION TO PROBLEM

In the present disclosure, a grease composition contains a liquid resin (A), poly(methacrylic acid)-based organic particles (B), and an inorganic filler (C). The liquid resin (A) contains at least one type selected from the group consisting of polyols, polyethers, and diamine resins. The poly(methacrylic acid)-based organic particles (B) are dissoluble in an organic solvent having a solubility parameter (SP value) of 7.8 to 10.1.

In the present disclosure, an electronic component includes a heat generation body, a heat dissipation body, and the grease composition of the present disclosure arranged in between the heat generation body and the heat dissipation body.

ADVANTAGEOUS EFFECT

In the present disclosure, the grease composition can reduce occurrence of pump-out at high temperatures, especially around 150°C, can maintain thermal conductivity, and can reduce occurrence of a void.

In the present disclosure, the electronic component can adequately exhibit thermal conductivity even when the heat generation body is at a high temperature of approximately 150°C, by arranging the grease composition of the present disclosure in between the heat generation body and the heat dissipation body. In the present disclosure, the electronic component has excellent long-term reliability because the electronic component can maintain the same and/or similar thermal conductivity even during use thereafter.

BRIEF DESCRIPTION OF THE DRAWINGS

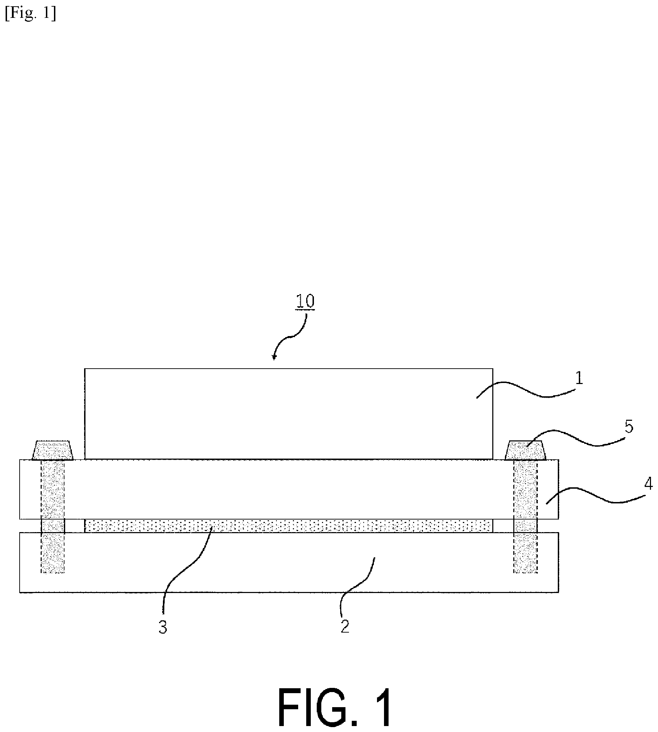

FIG. 1 is a schematic view illustrating an overall configuration of an embodiment of an electronic component of the present disclosure.

DESCRIPTION OF EMBODIMENTS

An embodiment of the present disclosure will be described in detail below.

Grease Composition

In the present embodiment, a grease composition contains a liquid resin (A) containing at least one type selected from the group consisting of polyols, polyethers, and diamine resins, poly(methacrylic acid)-based organic particles (B) dissoluble in a solvent having a solubility parameter (SP value) of 7.8 to 10.1, and an inorganic filler (C).

In the present description, grease means a semisolid or solid resulting from dispersion of a thickener into a raw material base oil, in accordance with JIS K 2220:2013. Note that "solid" includes a gel having lost fluidity as an overall system.

In the present embodiment, the grease composition (hereinafter, also referred to as "present grease composition") is a composition having properties of grease. The present grease composition becomes a gel from a semisolid by losing fluidity by an action of the poly(methacrylic acid)-based organic particles (B) due to heating as described below. Hereinafter, among the present grease composition, a gelled grease composition is also referred to as "present gelled composition".

In the present description, liquid of a liquid resin refers to being a liquid at ambient temperature. Specifically, the liquid component refers to a component having a viscosity of not more than 200000 mPa s, and the viscosity is measured by a type E viscometer (e.g., VISCOMETER TPE-100, available from Toki Sangyo Co., Ltd.) at 25°C. Hereinafter, unless otherwise noted, the viscosity of a liquid substance refers to a viscosity measured by a type E viscometer (e.g., VISCOMETER TPE-100, available from Toki Sangyo Co., Ltd.) at 25°C. In the present description, ambient temperature refers to 5 to 40°C, and preferably 15 to 30°C.

The present grease composition is used in an electronic component, for example, by being arranged in between a heat generation body and a heat dissipation body in a heat generation component. In this case, at least one of the heat generation body or the heat dissipation body has the present grease composition applied at ambient temperature. The heat generation body and the heat dissipation body are then arranged by interposing the grease composition between the heat generation body and the heat dissipation body. Alternatively, arrangement is performed by a process by which, for example, the present grease composition is injected in between the heat generation body and the heat dissipation body arranged in a predetermined distance.

Since the present grease composition has grease properties and has the viscosity described below, the present grease composition can be applied or injected in between the heat generation body and the heat dissipation body in the heat generation component with good workability, and makes assembly of the electronic component easier without thermal treatment such as drying.

When the heat generation component having the present grease composition applied reaches a high temperature such as approximately 150°C during use, the present grease composition undergoes gelation during the temperature increase and becomes the present gelled composition. Note that, in the present grease composition, gelation is achieved by swelling of the poly(methacrylic acid)-based organic particles (B) by the liquid resin (A) among the constituents of the present grease composition. The temperature at which gelation of the present grease composition starts is approximately 60 to 130°C although the temperature also depends on the types of the liquid resin (A) and the poly(methacrylic acid)-based organic particles (B). In this way, when the heat generation component reaches a high temperature such as approximately 150°C, the present grease composition changes into the present gelled composition having less fluidity due to the temperature change. Accordingly, pump-out almost does not occur in between the heat generation body and the heat dissipation body. The liquid resin (A) infiltrates into the poly(methacrylic acid)-based organic particles (B) and makes the poly(methacrylic acid)-based organic particles (B) swollen, a volatile component in the liquid resin (A) is less likely to volatilize. Accordingly, the present gelled composition can reduce occurrence of a void.

Because the present gelled composition resulting from gelation of the present grease composition has flexibility, even when the heat generation body and the heat dissipation body undergo change of form due to temperature decrease, the present gelled composition can exhibit excellent followability to the change of form, exhibit excellent adhesiveness even at low temperatures, and maintain the thermal conductivity. The present gelled composition can also reduce occurrence of a volatile component.

When the present grease composition is used in a heat generation component, the present grease composition undergoes gelation at a high temperature condition as described above. The present grease composition keeps being gelled, in other words, in a state of the present gelled composition, and stays in between the heat generation body and the heat dissipation body even when the temperature goes back from the high temperature to ambient temperature. Thereafter, even when the heat generation body repeats temperature increase and decrease, the present gelled composition, which is the gelled present grease composition, can maintain the effects described above because change of properties accompanying the temperature change is small. As a result, the heat generation component can be used stably for a long term.

The components contained in the present grease composition will be described below.

Liquid Resin (A)

The liquid resin (A) contained in the present grease composition is a resin that is liquid at ambient temperature and is a resin containing at least one type selected from the group consisting of polyols, polyethers, and diamine resins. The definition of the liquid is as described above. The liquid resin (A) is a component that makes the present grease composition into a grease form by being mixed with a solid component contained in the present grease composition, specifically, the poly(methacrylic acid)-based organic particles (B) and the inorganic filler (C). The liquid resin (A) has a function of making the present grease composition gelled to form the present gelled composition by infiltrating into the poly(methacrylic acid)-based organic particles (B) by heating and making the poly(methacrylic acid)-based organic particles (B) swollen. Accordingly, the present grease composition can reduce increase of fluidity accompanying temperature change during use.

The thermal resistance of the liquid resin (A) is affected mainly by backbone of the resin. In particular, presence of an aromatic ring in the resin affects weight reduction at high temperatures. The liquid resin (A) can provide a grease composition having excellent long-term reliability because of having such thermal resistance. The liquid resin (A) may be a resin having a low hygroscopicity. Because of the low hygroscopicity of the liquid resin (A), occurrence of a void can decrease. The liquid resin (A) is selected from the group consisting of the specific types of resins described above but may be a heat-resistant resin with small weight reduction.

When the liquid resin (A) contains two or more types of resins, a mixture resulting from mixing of the two or more types of resins is only required to be in a liquid form. The liquid resin (A) may be resulting from mixing of a solid resin and a liquid resin.

The liquid resin (A) may have a viscosity at 25°C measured by a type E viscometer, e.g., VISCOMETER TPE-100, available from Toki Sangyo Co., Ltd., of 10 to 10000 mPa s, or 100 to 1000 mPa s.

The liquid resin (A) may have a mass reduction rate at 150°C, based on a mass at 25°C, of less than 1%. The lower limit of the mass reduction rate is not particularly limited. Setting the mass reduction rate to less than 1% can, for example, reduce the volatile component when the present grease composition is arranged in between a heat generation body and a heat dissipation body at the time of use in a heat generation component, and can reduce reduction in heat dissipation characteristics caused by occurrence of a void.

The mass reduction rate can be calculated as a mass change rate (reduction rate) before and after heating when the liquid resin (A) is left in an oven at 150°C for 24 hours.

From the perspective of allowing the poly(methacrylic acid)-based organic particles (B) to be swollen efficiently, the liquid resin (A) may have a high compatibility with the poly(methacrylic acid)-based organic particles (B). Specifically, the SP value of the liquid resin (A) and the SP value of the poly(methacrylic acid)-based organic particles (B) may be close. The SP value of the liquid resin (A) may be from 7.3 to 11.5.

The SP value is a value defined by the regular solution theory introduced by Hildebrand. For example, the smaller the difference between solubility parameters (SP values) of two components, the larger the solubility is.

Note that the SP value of the liquid resin (A) can be measured in the same manner that the SP value of the poly(methacrylic acid)-based organic particles (B) is measured as described below.

Note that, when the liquid resin (A) contains two or more types of resins, the SP value of the mixed resin resulting from mixing of the two or more types of resins is only required to be close to the SP value of the poly(methacrylic acid)-based organic particles (B). When two or more types are mixed and used as the liquid resin (A), an SP value of each resin to be mixed may be close to the SP value of the poly(methacrylic acid)-based organic particles (B).

The resin used as the liquid resin (A) will be further described below.

Examples of the polyols include polylactone polyols, polycarbonate polyols, aromatic polyols, alicyclic polyols, aliphatic polyols, polycaprolactone polyols, castor oilbased polyols, ethylene-vinyl acetate copolymers, polyether polyols, and polyester polyols. One type of these polyols can be used alone, or two or more types of these polyols can be mixed and used.

From the perspective of achieving low viscosity and thermal resistance, the polyols may be polyester polyols.

Examples of the polyester polyols include polyols having a polyhydric alcohol-polyhydric carboxylic acid condensed system and polyols having a cyclic ester ring-opened polymer system.

Specific product examples of the polyester polyols include UNISTER (trade name) HR-32 and UNISTER (trade name) H-809RB, available from NOF Corporation.

Examples of the polyethers include aromatic hydrocarbon-based and phenyl ether-based polyethers. One type of the polyethers may be used alone, or the polyether may be mixed and used with a polyol or a diamine resin. In a case of mixing, the ratio of polyether and polyol or diamine resin, in terms of mass ratio, may be from 50:50 to 95:5 and, from the perspective of thermal resistance, may be from 70:30 to 95:5.

Examples of the aromatic hydrocarbon-based polyethers include polyethylene terephthalate, polybutylene terephthalate, polybutylene naphthalate, polystyrene, polysulfone, polyethersulfone, polyphenylene sulfide, polyphenylsulfone, polyarylate, polyetherimide, polyimide, and polyamide-imide. One type of these aromatic hydrocarbon-based polyethers can be used alone, or two or more types of these aromatic hydrocarbon-based polyethers can be mixed and used.

The phenyl ether-based polyethers include phenyl ether resins and alkyl phenyl ether resins. Specific examples include diphenyl ether, tetraphenyl ether, pentaphenyl ether, alkyl diphenyl ether, monoalkyl triphenyl ether, monoalkyl tetraphenyl ether, dialkyl tetraphenyl ether, polyethylene glycol, polypropylene glycol, polybutylene glycol, poly(1-methylbutylene glycol)perfluoro polyether, polyether monool, polyether diol, and polyether triol. One type of these phenyl ether-based polyethers can be used alone, or two or more types of these phenyl ether-based polyethers can be mixed and used.

The polyether may be a polyether containing a phenyl ether from the perspective of thermal resistance.

Specific product examples of the phenyl ether-based polyether include LB-100, S-3105, S-3103, S-3101, and S-3230, available from MORESCO Corporation.

Examples of the diamine resin include p-phenylenediamine (PDA), m-phenylenediamine, 4,4'-oxydianiline (ODA), 3,3'-bis(trifluoromethyl)-4,4'-diaminobiphenyl (TFMB), 3,4'-diaminodiphenyl ether, 4,4'-diaminodiphenylmethane, 3,3'-dimethyl-4,4'-diaminodiphenylmethane, 2,2-bis[4-(4-aminophenoxy)phenyl]propane, 1,2-bis(anilino)ethane, diaminodiphenyl sulfone, diaminobenzanilide, diaminobenzoate, diaminodiphenyl sulfide, 2,2-bis(p-aminophenyl)propane, 2,2-bis(p-aminophenyl)hexafluoropropane, 1,5-diaminonaphthalene, diaminotoluene, diaminobenzotrifluoride, 1,4-bis(p-aminophenoxy)benzene, 4,4'-bis(p-aminophenoxy)biphenyl, diaminoanthraquinone, 4,4'-bis(3-aminophenoxyphenyl)diphenylsulfone, and poly(tetramethylene oxide)-di-p-aminobenzoate. One type of these diamine resins can be used alone, or two or more types of these diamine resins can be mixed and used.

The diamine resin may be a poly(tetramethylene oxide)-di-p-aminobenzoate from the perspective of thermal resistance.

Specific product examples of the diamine resin include ELASMER 1000P, available from Kumiai Chemical Industry Co., Ltd.

The liquid resin (A) may contain a polyether from the perspective of thermal resistance. When the liquid resin (A) contains a polyether, the content of the polyether may be from 50 to 95 mass%, or may be from 70 to 95 mass%, in the liquid resin (A).

The liquid resin (A) may optionally contain another resin besides the polyol, the polyether, and the diamine resin. Examples of such another resin include epoxy resins and oxetane resins.

When the liquid resin (A) contains another resin, the content of such another resin may be not more than 10 mass%, not more than 5 mass%, or not more than 3 mass%.

In the present grease composition, the content of the liquid resin (A) may be from 5 to 30 mass%, or from 5 to 10 mass%, with respect to the total amount of the present grease composition. When the content of the liquid resin (A) is not less than 5 mass%, the viscosity of the present grease composition does not become excessively high, and the present grease composition easily achieves semisolid properties. When the content of the liquid resin (A) is not more than 30 mass%, the viscosity of the present grease composition does not become excessively low, and workability is improved.

Poly(Methacrylic Acid)-Based Organic Particles (B)

The poly(methacrylic acid)-based organic particles (B) used in the present grease composition can adjust the viscosity of the present grease composition when mixed with the liquid resin (A) together with the inorganic filler (C) at ambient temperature. When heated to not lower than a designated temperature, the poly(methacrylic acid)-based organic particles (B) can make the present grease composition gelled by allowing the liquid component contained in the present grease composition, mainly the liquid resin (A), to infiltrate into and make the poly(methacrylic acid)-based organic particles (B) swollen. Specifically, the poly(methacrylic acid)-based organic particles (B) are particles of an organic compound having the functions described above. In the present grease composition, the designated temperature is approximately 60 to 130°C although the designated temperature also depends on the types of the liquid resin (A) and the poly(methacrylic acid)-based organic particles (B).

The organic compound constituting the poly(methacrylic acid)-based organic particles (B) may have good compatibility with the liquid resin (A) as described above. Specifically, the SP value of the poly(methacrylic acid)-based organic particles (B) may be close to the SP value of the liquid resin (A). When the SP value of the poly(methacrylic acid)-based organic particles (B) is close to the SP value of the liquid resin (A), swellability of the poly(methacrylic acid)-based organic particles (B) becomes high, and gelation of the present grease composition suitably proceeds.

The poly(methacrylic acid)-based organic particles (B) are selected from the group consisting of poly(methacrylic acid)-based organic particles dissoluble in a solvent having an SP value of 7.8 to 10.1. Note that, in the present description, "dissoluble in a solvent having an SP value of 7.8 to 10.1" of the liquid resin (A) or the poly(methacrylic acid)-based organic particles (B) only requires being dissolved in any one of solvents having an SP value of 7.8 to 10.1 and may mean being dissolved in a plurality of solvents having different SP values. As the measurement method, an SP value of a solvent can be calculated by using the method of Fedors. Specifically, whether dissolution can be achieved in a solvent having an SP value of 7.8 to 10.1 can be measured by the method described in Examples.

As a solvent that is subjected to the determination of whether the poly(methacrylic acid)-based organic particles (B) can be dissolved, for example, a solvent having an SP value of 7.0 to 12.7 can be used without particular limitation as long as the solvent has such characteristics. Examples of this solvent include n-pentane (SP value: 7.0), n-hexane (SP value: 7.3), ethylhexyl acrylate (SP value: 7.8), cyclohexane (SP value: 8.9), ethyl benzene (SP value: 9.0), methyl ethyl ketone (SP value: 9.1), acetone (SP value: 9.9), acetic acid (10.1), isopropyl alcohol (IPA) (SP value: 11.5), and ethanol (SP value: 12.7).

Regarding the solubility in a solvent, the poly(methacrylic acid)-based organic particles (B) may dissolve in all of solvents having SP values of 7.8 to 10.1.

An organic compound constituting the poly(methacrylic acid)-based organic particles (B) may be an acrylic resin or a polymethacrylate. Note that the acrylic resin is a resin resulting from polymerization of acrylic acid, methacrylic acid, and derivatives thereof as main monomers and may contain a polymerization unit of another vinyl group-containing monomer. The polymethacrylate is a resin resulting from polymerization of methacrylate as a main constituent monomer, may contain a polymerization unit of a monomer other than the methacrylate, and may be a partially crosslinked material. From the perspective of swellability, the polymethacrylate may be a non-crosslinked material. Specific examples of the polymethacrylate include resins each containing an alkyl methacrylate polymer, an alkyl methacrylate copolymer, an alkyl methacrylic acid ester copolymer, and an alkyl acrylate-alkyl methacrylate copolymer as a main component. "Main component" refers to a component having the content of more than 50 mass%.

The poly(methacrylic acid)-based organic particles (B) may contain at least one type selected from the group consisting of poly(alkyl methacrylate) particles, poly(alkyl methacrylic acid) ester particles, and alkyl acrylate-alkyl methacrylate resin particles.

From the perspective of achieving good swellability, the average degree of polymerization of the poly(methacrylic acid)-based organic particles (B) may be from 1000 to 50000, from 3000 to 40000, or from 4000 to 30000. When the average degree of polymerization is not less than 1000, the poly(methacrylic acid)-based organic particles (B) adequately swell and exhibit pump-out resistance in the present grease composition or the present gelled composition. When the average degree of polymerization is not more than 50000, flexibility of the present gelled composition becomes good, and occurrence of cracking or peeling can decrease.

The average particle diameter of the poly(methacrylic acid)-based organic particles (B) may be not less than 0.1 $\mu$m and not more than 10.0 $\mu$m, or not less than 0.3 $\mu$m and not more than 5.0 $\mu$m. Note that, in the present description, the average particle diameter is a cumulative average particle diameter D50 based on volume, measured by a dynamic light scattering particle size measurement device. When the average particle diameter of the poly(methacrylic acid)-based organic particles (B) is not less than 0.1 $\mu$m, if swollen, the poly(methacrylic acid)-based organic particles (B) occupy spaces in the inorganic filler (C) and improve thermal conductivity. When the average particle diameter of the poly(methacrylic acid)-based organic particles (B) is not more than 10.0 $\mu$m, the poly(methacrylic acid)-based organic particles (B) adequately disperse in the present grease composition.

The poly(methacrylic acid)-based organic particles (B) may be core-shell type particles. One type of the poly(methacrylic acid)-based organic particles (B) may be used alone, or two or more types of the poly(methacrylic acid)-based organic particles (B) may be mixed and used.

Examples of commercially available poly(methacrylic acid)-based organic particles (B) include ZEFIAC F301, F303, F320, F325, F340M, and F351, available from Aica Kogyo Co., Ltd.

In the present grease composition, the content of the poly(methacrylic acid)-based organic particles may be from 5 to 30 parts by mass, or from 7 to 25 parts by mass, with respect to 100 parts by mass of the liquid resin (A). When the content of the poly(methacrylic acid)-based organic particles (B) is not less than 5 parts by mass, when the resulting grease composition is heated, gelation occurs adequately, and pump-out due to viscosity decrease can decrease. When the content of the poly(methacrylic acid)-based organic particles (B) is not more than 30 parts by mass, flexibility of the present gelled composition becomes good, and occurrence of cracking or peeling can decrease.

Inorganic Filler (C)

The inorganic filler (C) used in the present grease composition is a component adjusting the viscosity of the present grease composition to grease-like, together with the poly(methacrylic acid)-based organic particles (B). The inorganic filler is not particularly limited as long as the inorganic filler (C) is an inorganic filler used for electronic components, and may be an inorganic filler having thermal conductivity. By using an inorganic filler having thermal conductivity as the inorganic filler (C), the present grease composition can have thermal conductivity. Examples of the inorganic filler having thermal conductivity include metal oxides, metal nitrides, nitride compounds, metals, graphite, silicon carbide, and silicon compounds, which have coefficients of thermal conductivity of not less than 10 W/m·K. Among these, the inorganic filler (C) may be aluminum oxide, boron nitride, silicon nitride, silicon carbide, or aluminum nitride. In particular, from the perspective of high thermal conductivity, the inorganic filler (C) may be aluminum oxide or aluminum nitride. One type of the inorganic filler (C) may be used alone, or two or more types of the inorganic fillers (C) may be mixed and used.

The shape of the inorganic filler (C) is not particularly limited and may be spherical or indefinite in shape. From the perspective of providing the present grease composition with uniform grease properties, the average particle diameter of the inorganic filler (C) may be from 0.1 to 40 $\mu$m, or from 0.2 to 30 $\mu$m.

The inorganic filler (C) may use a combination of inorganic fillers having different average particle diameters, e.g., a combination of an inorganic filler (Ca) having a large average particle diameter and an inorganic filler (Cb) having a small average particle diameter. The combination of inorganic fillers having different average particle diameters can increase a packing factor of the inorganic filler (C) in the present grease composition. Note that suitable ranges of the average particle diameters of the inorganic fillers (Ca) and (Cb) can be selected based on the materials of the inorganic fillers (Ca) and (Cb).

For example, when the inorganic filler (C) is aluminum nitride particles, a combination of aluminum nitride particles (Ca-1) having an average particle diameter of 20 to 40 $\mu$m and aluminum nitride particles (Cb-1) having an average particle diameter of 1 to 10 $\mu$m may be used. The combination of the aluminum nitride particles (Ca-1) and the aluminum nitride particles (Cb-1) can increase a packing factor of the inorganic filler (C) in the present grease composition. When the combination of the aluminum nitride particles (Ca-1) and the aluminum nitride particles (Cb-1) is used, the mass ratio of the aluminum nitride particles (Ca-1) and the aluminum nitride particles (Cb-1) may be in a range of 10:90 to 80:20, or in a range of 50:50 to 80:20, when the total of the mixture is 100. The mixing ratio in a range of 10:90 to 80:20 can provide suitable closest packing and improve the coefficient of thermal conductivity.

For example, when the inorganic filler (C) is aluminum oxide particles, a combination of aluminum oxide particles (Ca-2) having an average particle diameter of 7 to 40 $\mu$m and aluminum oxide particles (Cb-2) having an average particle diameter of 0.5 to 5 $\mu$m can increase a packing factor of the inorganic filler (C) in the present grease composition. When the combination of the aluminum oxide particles (Ca-2) and the aluminum oxide particles (Cb-2) is used, the mass ratio of the aluminum oxide particles (Ca-2) and the aluminum oxide particles (Cb-2) may be in a range of 40:60 to 95:5, or in a range of 50:50 to 90:10, when the total of the mixture is 100. The mixing ratio in a range of 40:60 to 95:5 can provide suitable closest packing and improve the coefficient of thermal conductivity.

In the present grease composition, the content of the inorganic filler (C) may be from 350 to 2000 parts by mass, from 500 to 1800 parts by mass, or from 800 to 1500 parts by mass, with respect to 100 parts by mass of the liquid resin (A). When the content of the inorganic filler (C) is not less than 350 parts by mass, the resulting grease composition can achieve a desired viscosity. When the content of the inorganic filler (C) is not more than 2000 parts by mass, workability at the time of production of the present grease composition is good, and the grease composition has appropriate fluidity. Thus, application or injection can easily arrange the present grease composition in a heat generation component.

In the present grease composition, the content of the inorganic filler (C) may be from 70 to 95 mass%, or from 80 to 95 mass%, with respect to the total amount of the present grease composition.

Silane Coupling Agent (D)

The present grease composition may contain a silane coupling agent (D). The silane coupling agent (D) is used to modify the surface texture of the inorganic filler (C), and a known silane coupling agent for this type of composition can be used.

As the type of the silane coupling agent (D), a silane coupling agent containing an amino group, a phenyl group, an epoxy group, an isocyanate group, an isocyanurate group, a vinyl group, a styryl group, a methacryl group, an acryl group, a ureido group, a titanate group, an acid anhydride, or the like can be used without particular limitation. When the present grease composition contains the silane coupling agent (D), one type of these silane coupling agents (D) may be used alone, or two or more types of these silane coupling agents (D) may be mixed and used. When the silane coupling agent (D) is used, after the silane coupling agent (D) directly treats the inorganic filler (C), the liquid resin (A) and the poly(methacrylic acid)-based organic particles (B) may be blended, or the liquid resin (A), the poly(methacrylic acid)-based organic particles (B), the inorganic filler (C), and the silane coupling agent (D) may be mixed together.

In the present grease composition, the content of the silane coupling agent (D) may be from 0.02 to 5 parts by mass, or from 0.03 to 2 parts by mass, with respect to 100 parts by mass of the inorganic filler (C).

In addition to the components described above, the present grease composition may optionally and appropriately contain additives such as antioxidants, weathering stabilizers, heat-resistant stabilizers, viscosity modifiers, anti-foaming agents, leveling agents, antisettling agents, dispersing agents, pigments, antistatic agents, and flame retardants. One type of these additives may be used alone, or two or more types of these additives may be mixed and used.

In the present grease composition, the content of each of these additives or a total content of these additives with respect to the total amount of the present grease composition can be set from approximately 0.05 mass% to 15 mass%, and may be from 0.2 mass% to 10 mass%.

In the present grease composition, the total content of the liquid resin (A), the poly(methacrylic acid)-based organic particles (B), and the inorganic filler (C) may be not less than 80 mass%, not less than 90 mass%, or not less than 95 mass%.

The present grease composition can be produced by weighing and blending the liquid resin (A), the poly(methacrylic acid)-based organic particles (B), and the inorganic filler (C), and optionally the silane coupling agent (D) and various additives described above in the contents described above, and mixing. The mixing method is not particularly limited and can be appropriately selected based on the type, viscosity, and content of each component. Specific examples include a method of using a mixer such as a dissolver mixer or a homomixer.

For example, optionally, the material resulting from the mixing described above may undergo filtration to remove aggregations of undispersed components. Such filtration can provide a uniform grease composition. Air bubbles formed in the composition during the mixing described above may be degassed under reduced pressure. Performing such degassing can reduce formation of air bubbles in the resulting grease composition.

The present grease composition has grease properties. That is, in the present grease composition, a viscosity at 25°C is approximately from 100 to 1000 Pa s and may be from 110 to 600 Pa s, or from 120 to 500 Pa s. The viscosity can be measured by using a rheometer and, specifically, can be measured by the method described in Examples.

The present grease composition starts gelation at approximately 60 to 130°C and becomes the present gelled composition. Thus, when the present grease composition is used for an application accompanying temperature changes, the present grease composition is used as the present gelled composition once the temperature exceeds the gelation starting temperature during temperature increase. Typically, fluidity of a resin composition increases as the temperature increases; however, the present gelled composition has properties in which fluidity is lost as the whole system or fluidity is reduced to a degree where slight flow is allowed. In the present gelled composition, a viscosity at 150°C is approximately from 190 to 10000 Pa s and may be from 200 to 5000 Pa s, or from 210 to 3000 Pa s. The viscosity can be measured by using a rheometer and, specifically, can be measured by the method described in Examples.

A viscosity ratio ($V_{150°C}/V_{25°C}$) can be used as an index to evaluate the property change of the present grease composition. The viscosity ratio ($V_{150°C}/V_{25°C}$) can be determined by measuring a viscosity at 25°C ($V_{25°C}$) and a viscosity at 150°C ($V_{150°C}$) using a rheometer and then calculating based on the resultant values of $V_{25°C}$ and $V_{150°C}$. The viscosity ratio ($V_{150°C}/V_{25°C}$) of the present grease composition of not less than 1.05 indicates properties as a gel.

Note that, in the present description, the viscosity V measured by a rheometer is a value measured at a designated temperature when the temperature is increased to the designated temperature, by using a rheometer (e.g., Kinexus pro+, available from Spectris). For example, $V_{150°C}$ is a value measured at 150°C under conditions of a temperature range of 25 to 200°C, a rate of temperature rise of 10°C/min, a rate of temperature decline of 10°C/min, a frequency of 1 Hz (constant), and a shear strength of 10 Pa (constant).

When a heat generation component uses the present grease composition having the viscosity ratio ($V_{150°C}/V_{25°C}$) of not less than 1.05 and the heat generation component reaches a high temperature, the present grease composition undergoes gelation and becomes the present gelled composition. Flow out (pump-out) of the present gelled composition from the heat generation component can be suppressed.

The coefficient of thermal conductivity (W/m·K) of the present grease composition may be not less than 1 W/m·K, or not less than 2 W/m·K. After the present grease composition undergoes cooling-heating cycles at set conditions of -40 to 150°C for 1000 cycles, the present grease composition becomes the present gelled composition, and the coefficient of thermal conductivity (W/m·K) of the present gelled composition may be not less than 1 W/m·K, or not less than 2 W/m·K. Note that the gelled composition resulting from gelation of the present grease composition tends to have a higher coefficient of thermal conductivity (W/m·K) compared to the coefficient of thermal conductivity of the present grease composition.

Electronic Component

FIG. 1 is a schematic view illustrating an overall configuration of an embodiment of the present electronic component.

As illustrated in FIG. 1, an electronic component 10 of the present embodiment (hereinafter, also referred to as "present electronic component") includes a heat generation body 1, a heat dissipation body 2, and the present grease composition 3 arranged in between the heat generation body 1 and the heat dissipation body 2. The heat generation body 1 may be provided on a substrate 4. The substrate 4 on which the heat generation body 1 is arranged, and the heat dissipation body 2 may be fixed by screws 5.

Examples of the electronic component include electronic devices and inverters, and the electronic component may be an electronic device. When the present electronic component is an electronic device, examples of the heat generation body include IC chips, CPU chips, and GPU chips. When the present electronic component is an inverter, examples of the heat generation body include IGBT, and examples of the heat dissipation body include heat sinks.

Examples of the method of arranging the present grease composition in between the heat generation body and the heat dissipation body include the application or injection described above. The application or injection can be performed same as and/or similarly to ordinary methods for application or injection of a grease product. When the present grease composition is applied or injected in between the heat generation body and the heat dissipation body in the present electronic component, upon the heat generation body reaching a high temperature such as approximately 150°C, the present grease composition undergoes gelation and becomes the present gelled composition in the process, and is present as the present gelled composition in between the heat generation body and the heat dissipation body during use thereafter.

The thickness of the present grease composition or the present gelled composition arranged in between the heat generation body and the heat dissipation body may be from 5 to 500 μm, or from 50 to 400 μm, from the perspective of improvement of pump-out resistance and heat dissipation.

EXAMPLES

Hereinafter, the present disclosure will be described specifically based on Examples and Comparative Examples, but the present disclosure is not limited to the examples described below.

Components

The raw materials used for preparation of Examples and Comparative Examples will be described below.

Liquid Resin (A)

A-1: Alkyl diphenyl ether (LB-100, available from MORESCO Corporation; viscosity at 25°C: 200 mPa·s; oxidation: <0.1 mgKOH/g; mass reduction rate: <0.1%; SP value: 7.3 to 9.1)
A-2: Pentaphenyl ether (S-3105, available from MORESCO Corporation; viscosity at 25°C: 570 mPa·s; oxidation:

<0.1 mgKOH/g; mass reduction rate: <0.1%; SP value: 7.3 to 9.1)

A-3: Tetraphenyl ether (S-3103, available from MORESCO Corporation; viscosity at 25°C: 240 mPa·s; oxidation: <0.1 mgKOH/g; mass reduction rate: <0.1%; SP value: 7.3 to 9.1)

A-4: Monoalkyl tetraphenyl ether (S-3101, available from MORESCO Corporation; viscosity at 25°C: 470 mPa·s; oxidation: <0.1 mgKOH/g; mass reduction rate: <0.1%; SP value: 7.3 to 9.1)

A-5: Dialkyl tetraphenyl ether (S-3230, available from MORESCO Corporation; viscosity at 25°C: 800 mPa·s; oxidation: <0.1 mgKOH/g; mass reduction rate: <0.1%; SP value: 7.3 to 9.1)

A-6: Polyester polyol (UNISTER (trade name) HR-32, available from NOF Corporation; viscosity at 25°C: 480 mPa·s; oxidation: 0.1 mgKOH/g; mass reduction rate: <0.1%; SP value: 7.3 to 9.1)

A-7: Polyester polyol (UNISTER (trade name) H-609BR, available from NOF Corporation; viscosity at 25°C: 900 mPa·s; oxidation: 0.1 mgKOH/g; mass reduction rate: <0.1%; SP value: 7.3 to 9.9)

A-8: Poly(tetramethylene oxide)-di-p-aminobenzoate (ELASMER 1000P, available from Kumiai Chemical Industry Co., Ltd.; viscosity at 25°C: 8000 mPa·s; amine value: 84.4 mgKOH/g; mass reduction rate: <0.1%; SP value: 8.9 to 11.5)

The viscosity at 25°C of the liquid resin (A) was measured by a type E viscometer (VISCOMETER TPE-100, available from Toki Sangyo Co., Ltd.).

The mass reduction rate of the liquid resin (A) was calculated as a mass change rate (reduction rate) before and after heating when 30 g of the liquid resin (A) was left in an oven at 150°C for 24 hours.

Poly(Methacrylic Acid)-Based Organic Particles (B)

B-1: Alkyl methacrylate polymer (ZEFIAC F320, available from Aica Kogyo Co., Ltd.; average particle diameter: 2 μm; average degree of polymerization: 30000)

B-2: Alkyl methacrylate copolymer (ZEFIAC F340M, available from Aica Kogyo Co., Ltd.; average particle diameter: 1 μm; average degree of polymerization: 30000)

B-3: Alkyl methacrylate polymer (ZEFIAC F325, available from Aica Kogyo Co., Ltd.; average particle diameter: 1 μm; average degree of polymerization: 40000)

B-4: Alkyl methacrylic acid ester copolymer (ZEFIAC F303, available from Aica Kogyo Co., Ltd.; average particle diameter: 2 μm; average degree of polymerization: 20000)

B-5: Alkyl methacrylic acid ester copolymer (ZEFIAC F301, available from Aica Kogyo Co., Ltd.; average particle diameter: 2 μm; average degree of polymerization: 20000)

B-6: Alkyl acrylate-alkyl methacrylate copolymer (ZEFIAC F351, available from Aica Kogyo Co., Ltd.; average particle diameter: 0.5 μm; average degree of polymerization: 40000)

Particles Other Than Poly(Methacrylic Acid)-Based Organic Particles (B)

Resin particle 1: Methyl methacrylate crosslinked product (EPOSTAR (trade name) MA1002, available from Nippon Shokubai Co., Ltd.; average particle diameter: 2 μm)

Resin particle 2: Methyl methacrylate crosslinked product (EPOSTAR (trade name) MA1004, available from Nippon Shokubai Co., Ltd.; average particle diameter: 4 μm)

Resin particle 3: Silicone rubber (KMP-597, available from Shin-Etsu Chemical Co., Ltd.; average particle diameter: 1 μm; average degree of polymerization: 30000)

Resin particle 4: Fluorine-based particles (L-173JE, available from AGC Inc.; average particle diameter: 2 μm; average degree of polymerization: 30000)

Methacrylate copolymer (liquid) (UH-2190, available from Toagosei Co., Ltd.; average degree of polymerization: <1000)

Inorganic Filler (C)

Ca-1: Aluminum nitride particles (FAN-f30, available from Furukawa Electric Co., Ltd.; average particle diameter: 30 μm)

Cb-1: Aluminum nitride particles (FAN-f05, available from Furukawa Electric Co., Ltd.; average particle diameter: 5 μm)

Ca-2: Aluminum oxide particles (AA-18, available from Sumitomo Chemical Co., Ltd.; average particle diameter: 20 μm)

Cb-2: Aluminum oxide particles (AA-1.5, available from Sumitomo Chemical Co., Ltd.; average particle diameter: 1.5 μm)

Silane Coupling Agent (D)

• D-1: 3-Glycidoxypropyltrimethoxysilane (Dynasylan (trade name) GLYMO, available from Evonik Japan Co., Ltd.)

Solubility of each of the liquid resin (A), the poly(methacrylic acid)-based organic particles (B) and the resin particles 1 to 4 other than the poly(methacrylic acid)-based organic particles (B) was determined. Ten types of solvents listed in Table 1 were prepared. In 5 g of each of these solvents having different SP values, 0.1 g of each of the components (A), the components (B), or the resin particles 1 to 4 was added and stirred for 1 hour by using a stirrer in an environment at room temperature (25°C). After stirring, the solubility was confirmed. For the solubility, a case where the mixture was transparent after the stirring was evaluated as adequately dissolved and indicated as "A", and a case where the mixture was semitransparent or cloudy was evaluated as not adequately dissolved and indicated as "C". The evaluation results are shown in Table 1.

[Table 1]

Table 1

| Solvent | | Liquid resin (A) | | | | | | | | Poly(methacrylic acid)-based organic particles (B) | | | | | | Resin particles | | | |
|---|---|---|---|---|---|---|---|---|---|---|---|---|---|---|---|---|---|---|---|
| | SP value [-] | A-1 | A-2 | A-3 | A-4 | A-5 | A-6 | A-7 | A-8 | B-1 | B-2 | B-3 | B-4 | B-5 | B-6 | 1 | 2 | 3 | 4 |
| n-Pentane | 7.0 | C | C | C | C | C | C | C | C | C | C | C | C | C | C | A | A | C | A |
| n-Hexane | 7.3 | A | A | A | A | A | A | A | C | C | C | C | C | C | C | C | C | C | C |
| Ethylhexyl acrylate | 7.8 | A | A | A | A | A | A | A | C | A | A | A | A | A | A | C | C | C | C |
| Cyclohexane | 8.9 | A | A | A | A | A | A | A | A | A | A | A | A | A | A | C | C | C | C |
| Ethylbenzene | 9.0 | A | A | A | A | A | A | A | A | A | A | A | A | A | A | C | C | C | C |
| Methyl ethyl ketone | 9.1 | A | A | A | A | A | A | A | A | A | A | A | A | A | A | C | C | C | C |
| Acetone | 9.9 | C | C | C | C | C | C | A | A | A | A | A | A | A | A | C | C | C | C |
| Acetic acid | 10.1 | C | C | C | C | C | C | C | A | A | A | A | A | A | A | C | C | C | C |
| Isopropyl alcohol | 11.5 | C | C | C | C | C | C | C | A | C | C | C | C | C | C | C | C | C | C |
| Ethanol | 12.7 | C | C | C | C | C | C | C | C | C | C | C | C | C | C | C | C | C | C |

Examples 1 to 23 and Comparative Examples 1 to 5

The compositions listed in Tables 2-1 to 2-3 were prepared by using the raw materials described above, and grease compositions of Examples 1 to 23 and Comparative Examples 1 to 5 were prepared. Note that a blank cell in Tables 2-1 to 2-3 indicates that the given component was not blended. The following evaluations were performed by using the prepared grease composition of each example. The results are shown in Tables 2-1 to 2-3.

(1) Viscosity Measured by Rheometer

From 5 to 10 g of the grease composition was measured by using a rheometer (Kinexus pro+, available from Spectris) under conditions of a temperature range of 25 to 200°C, a rate of temperature rise of 10°C/min, a frequency of 1 Hz (constant), and a shear strength of 10 Pa (constant). $V_{25°C}$ indicates a viscosity at 25°C, and $V_{150°C}$ indicates a viscosity at 150°C. Based on the values of $V_{25°C}$ and $V_{150°C}$, a viscosity ratio ($V_{150°C}/V_{25°C}$) was calculated.

(2) Pump-out Resistance

From 0.5 to 1.0 g of the grease composition was dropped on a substantially center of a glass slide provided with 150 $\mu$m spacers, then the grease composition was sandwiched using a glass slide (short side 26 mm $\times$ long side 76 mm $\times$ thickness 1.3 mm) with no spacers, and the grease composition was formed into a circular shape having a diameter of 10 mm. At this time, the grease composition did not spread out from the glass slide. Both of the sides of the three-layered body of glass slide/grease composition/glass slide were fixed by clips. The clamping force of the clips was 2.5 kg. The three-layered body was placed vertically in a manner that the long side was at the bottom, cooling-heating cycle test was performed by using a cooling-heating cycle tester (product name: TSA-100S-W, available from ESPEC Corp.) under set conditions of -40 to 150°C for 1000 cycles (retention time: 30 minutes, temperature increase time: 10°C/sec, temperature decrease time: 10°C/sec). After the cooling-heating cycle test, the three-layered body was taken out, and the condition of the grease composition or the gelled product thereof in between the glass slides was visually observed and evaluated by the following criteria.

A: Dripping was less than 3 mm.

C: Dripping was not less than 3 mm.

(3) Formation of Void

From 0.5 to 1.0 g of the grease composition was dropped on a substantially center of a glass slide provided with 150 $\mu$m spacers, then the grease composition was sandwiched using a glass slide (short side 26 mm $\times$ long side 76 mm $\times$ thickness 1.3 mm) with no spacers, and the grease composition was formed into a circular shape having a diameter of 10 mm. At this time, the grease composition did not spread out from the glass slide. Both of the sides of the three-layered body of glass slide/grease composition/glass slide were fixed by clips. The clamping force of the clips was 2.5 kg.

The sample fixed by the clips was horizontally placed on a hot plate adjusted to 150°C and heated for 1 minute. An image of the condition after 1 minute of the heating was taken by using a microscope (nano.capture PRO, available from Sightron Japan Inc.) and subjected to binarization processing by using the image processing software Image-J. Using the image after the binarization processing, a void percentage was calculated by the following equation and evaluated by the following criteria. Note that, in the following evaluation, A and B are passing.

$$\text{Void percentage (\%)} = \text{area (mm}^2) \text{ of void portion/area (mm}^2) \text{ of grease having a diameter of } 10 \text{ mm}$$

A: The void percentage was less than 3%.

B: The void percentage was not less than 3% and less than 6%.
C: The void percentage was not less than 6%.

(4) Coefficient of Thermal Conductivity (Before and After Cooling-Heating Cycle Test, After Continuous Heating at 150°C)

A coefficient of thermal conductivity was measured by using a diffusivity measurement instrument (LFA 467, available from NETZSCH Japan K.K.). In an aluminum cup container having a diameter of 12.7 mm, the grease composition was placed and covered with an aluminum rid having a diameter of 9 mm, and thus a three-layered structure was formed. The grease composition was placed in a holder for liquid measurement in a manner that the thickness of the grease composition was adjusted to 350 $\mu$m $\pm$ 50 $\mu$m. Correction processing was performed for the thermal diffusivity obtained by the xenon flash method to exclude a thermal diffusivity of aluminum, and thus a thermal diffusivity including interface thermal resistance was obtained. A coefficient of thermal conductivity was calculated by introducing the obtained thermal diffusivity including interface thermal resistance and the density and specific heat of the grease composition into Formula (1) below and used as a coefficient of thermal conductivity before the cooling-heating cycle test. The density was measured by using a high precision electronic densimeter (SD-200L, available from Alfa Mirage Co., Ltd.). The specific heat was measured by using a differential scanning calorimeter (DSC-6200, available from Seiko Instruments Inc.).

$$\text{Coefficient of thermal conductivity (W/m·K)} = \text{thermal diffusivity (mm}^2\text{/s)} \times \text{density (g/cm}^3\text{)} \times \text{specific heat (J/(kg·K))} \ ... \ (1)$$

From the three-layered body after the cooling-heating cycle test was performed for the evaluation of the pump-out resistance described above, the grease composition or the gelled material thereof was taken out from the glass slides. The coefficient of thermal conductivity was calculated by the same method as (4) described above and used as a coefficient of thermal conductivity after the cooling-heating cycle test.

In a 50 cc glass tube, 50 g of the grease composition was placed and heated for 1000 hours in a heat drying oven at 150°C, and thus a gelled material was produced. After the produced gelled material was cooled to ambient temperature (25°C), the coefficient of thermal conductivity was calculated by the same method as (4) described above and used as a coefficient of thermal conductivity after 150°C continuous heating.

(5) Mass Reduction Rate (%)

In a 50 cc glass tube, 50 g of the grease composition was placed, and cooling-heating cycle test was performed by using a cooling-heating cycle tester under set conditions of -40 to 150°C for 1000 cycles. The mass reduction rate (change rate) was calculated based on a mass W1 before the cooling-heating cycle test and a mass W2 after the cooling-heating cycle test of the grease composition.

(6) Thermal Resistance Value

The grease composition is applied in a thickness of 150 $\mu$m on a metal base substrate side of a semiconductor power module component (length 106 mm $\times$ width 61 mm $\times$ thickness 30 mm, TjMAX of element: 150°C), available from Infineon. The component was installed on a copper plate having a length 210 mm $\times$ width 60 mm $\times$ thickness 10 mm. Installation was performed by placing screws for six tapped holes and fixing at a tightening torque of 200 cN/cm. The copper plate to which the semiconductor power module was installed was placed vertically, and an element in the component generated heat by application of a voltage to terminals of the semiconductor power module. The voltage was turned on and off (retention time: 3 seconds) for 5000 cycles, and the thermal resistance after the 5000 cycles was evaluated.

[Table 2-1]

Table 2-1

| | | | Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| Grease composition [part by mass] | Liquid resin (A) | A-1 | 85 | 92 | 75 | 85 | 85 | 85 | 92 | 75 | 85 | 85 | 85 | |
| | | A-2 | | | | | | | | | | | | 85 |
| | | A-3 | | | | | | | | | | | | |
| | | A-4 | | | | | | | | | | | | |
| | | A-5 | | | | | | | | | | | | |
| | | A-6 | 15 | 8 | 25 | | | 15 | 8 | 25 | | | 15 | 15 |
| | | A-7 | | | | 15 | | | | | 15 | | | |
| | | A-8 | | | | | 15 | | | | | 15 | | |
| | Poly(methacrylic acid)-based organic particles (B) | B-1 | 15 | 15 | 15 | 15 | 15 | 15 | 15 | 15 | 15 | 15 | 6 | 15 |
| | | B-2 | | | | | | | | | | | | |
| | | B-3 | | | | | | | | | | | | |
| | | B-4 | | | | | | | | | | | | |
| | | B-5 | | | | | | | | | | | | |
| | | B-6 | | | | | | | | | | | | |
| | Particles other than poly(methacrylic acid)-based organic particles (B) | Resin particle 1 | | | | | | | | | | | | |
| | | Resin particle 2 | | | | | | | | | | | | |
| | | Resin particle 3 | | | | | | | | | | | | |
| | | Resin particle 4 | | | | | | | | | | | | |
| | Methacrylate copolymer (liquid) | | | | | | | | | | | | | |
| | Inorganic filler (C) | Ca-1 | 840 | 840 | 840 | 840 | 840 | | | | | | | |
| | | Cb-1 | 360 | 360 | 360 | 360 | 360 | | | | | | | |

| | | | | | | | | | | | | | |
|---|---|---|---|---|---|---|---|---|---|---|---|---|---|
| | Ca-2 | | | | | | 945 | 945 | 945 | 945 | 945 | 945 | 945 |
| | Cb-2 | | | | | | 405 | 405 | 405 | 405 | 405 | 405 | 405 |
| Silane coupling agent (D) | D-1 | 0.5 | 0.5 | 0.5 | 0.5 | 0.5 | 0.5 | 0.5 | 0.5 | 0.5 | 0.5 | 0.5 | 0.5 |
| Property value | Viscosity [Pa·s] $V_{25°C}$ | 255 | 280 | 220 | 378 | 510 | 140 | 180 | 125 | 215 | 490 | 110 | 160 |
| | Viscosity [Pa·s] $V_{150°C}$ | 680 | 740 | 590 | 1010 | 2350 | 380 | 410 | 330 | 570 | 1300 | 210 | 430 |
| | Viscosity ratio ($V_{150°C}/V_{25°C}$) [—] | 2.7 | 2.6 | 2.7 | 2.7 | 4.6 | 2.7 | 2.3 | 2.6 | 2.7 | 2.7 | 1.9 | 2.7 |
| | Pump-out resistance [—] | A | A | A | A | A | A | A | A | A | A | A | A |
| | Void formation [—] | A | A | A | A | A | B | A | B | A | A | B | A |
| | Coefficient of thermal conductivity [W/m·K] — Before cooling-heating cycle test | 4.1 | 4.3 | 4.1 | 4.1 | 4.0 | 2.2 | 2.3 | 2.2 | 2.1 | 2.0 | 2.0 | 2.1 |
| | Coefficient of thermal conductivity [W/m·K] — After cooling-heating cycle test | 4.9 | 5.0 | 4.8 | 4.8 | 4.6 | 3.0 | 3.1 | 2.9 | 2.8 | 2.8 | 2.2 | 2.9 |
| | Coefficient of thermal conductivity [W/m·K] — After continuous heating at 150°C | 4.9 | 5.0 | 4.6 | 4.8 | 4.6 | 3.0 | 3.1 | 2.8 | 2.8 | 2.8 | 2.2 | 2.9 |
| | Mass reduction rate [%] | 0.4 | 0.2 | 0.4 | 0.3 | 0.3 | 0.5 | 0.2 | 0.5 | 0.3 | 0.3 | 0.5 | 0.4 |
| | Thermal resistance value [°C/W] | 1.5 | 1.3 | 1.5 | 1.5 | 1.6 | 2.3 | 2.3 | 2.3 | 2.8 | 3.0 | 2.5 | 2.5 |

[Table 2-2]

Table 2-2

| | | | Example | | | | | | | | | | |
|---|---|---|---|---|---|---|---|---|---|---|---|---|---|
| | | | 13 | 14 | 15 | 16 | 17 | 18 | 19 | 20 | 21 | 22 | 23 |
| Grease composition [part by mass] | Liquid resin (A) | A-1 | | | | 85 | 85 | 85 | 85 | 85 | 100 | | |
| | | A-2 | | | | | | | | | | | |
| | | A-3 | 85 | | | | | | | | | | |
| | | A-4 | | 85 | | | | | | | | | |
| | | A-5 | | | 85 | | | | | | | | |
| | | A-6 | 15 | 15 | 15 | 15 | 15 | 15 | 15 | 15 | | 100 | |
| | | A-7 | | | | | | | | | | | |
| | | A-8 | | | | | | | | | | | 100 |
| | Poly(methacrylic acid)-based organic particles (B) | B-1 | 15 | 15 | 15 | | | | | | 15 | 15 | 15 |
| | | B-2 | | | | 15 | | | | | | | |
| | | B-3 | | | | | 15 | | | | | | |
| | | B-4 | | | | | | 15 | | | | | |
| | | B-5 | | | | | | | 15 | | | | |
| | | B-6 | | | | | | | | 15 | | | |
| | Particles other than poly(methacrylic acid)-based organic particles (B) | Resin particle 1 | | | | | | | | | | | |
| | | Resin particle 2 | | | | | | | | | | | |
| | | Resin particle 3 | | | | | | | | | | | |
| | | Resin particle 4 | | | | | | | | | | | |
| | Methacrylate copolymer (liquid) | | | | | | | | | | | | |
| | Inorganic filler (C) | Ca-1 | | | | | | | | | | | |

EP 4 223 843 A1

| | | Cb-1 | | | | | | | | | | | |
|---|---|---|---|---|---|---|---|---|---|---|---|---|---|
| | | Ca-2 | 945 | 945 | 945 | 945 | 945 | 945 | 945 | 945 | 945 | 945 | 945 |
| | | Cb-2 | 405 | 405 | 405 | 405 | 405 | 405 | 405 | 405 | 405 | 405 | 405 |
| | Silane coupling agent (D) | D-1 | 0.5 | 0.5 | 0.5 | 0.5 | 0.5 | 0.5 | 0.5 | 0.5 | 0.5 | 0.5 | 0.5 |
| Property value | Viscosity [Pa·s] | $V_{25°C}$ | 145 | 165 | 205 | 130 | 135 | 125 | 125 | 150 | 590 | 110 | 580 |
| | | $V_{150°C}$ | 390 | 440 | 550 | 350 | 365 | 335 | 340 | 405 | 770 | 290 | 4320 |
| | Viscosity ratio ($V_{150°C}/V_{25°C}$) [—] | | 2.7 | 2.7 | 2.7 | 2.7 | 2.7 | 2.7 | 2.7 | 2.7 | 1.3 | 2.6 | 7.4 |
| | Pump-out resistance [—] | | A | A | A | A | A | A | A | A | A | A | A |
| | Void formation [—] | | B | A | A | B | B | B | B | A | A | B | A |
| | Coefficient of thermal conductivity [W/m·K] | Before cooling-heating cycle test | 2.2 | 2.1 | 2.0 | 2.3 | 2.3 | 2.3 | 2.3 | 2.0 | 2.2 | 2.1 | 2.4 |
| | | After cooling-heating cycle test | 3.0 | 2.8 | 2.8 | 3.1 | 3.1 | 3.1 | 3.1 | 2.7 | 2.2 | 2.0 | 2.0 |
| | | After continuous heating at 150°C | 3.0 | 2.8 | 2.8 | 3.1 | 3.1 | 3.1 | 3.1 | 2.7 | 2.2 | 2.0 | 2.0 |
| | Mass reduction rate [%] | | 0.5 | 0.3 | 0.1 | 0.5 | 0.5 | 0.5 | 0.5 | 0.4 | 0.1 | 0.5 | 0.2 |
| | Thermal resistance value [°C/W] | | 2.4 | 2.7 | 2.8 | 2.2 | 2.2 | 2.1 | 2.2 | 2.6 | 3.0 | 3.1 | 3.8 |

[Table 2-3]

Table 2-3

| | | | | Comparative example | | | | |
|---|---|---|---|---|---|---|---|---|
| | | | | 1 | 2 | 3 | 4 | 5 |
| Grease composition [part by mass] | Liquid resin (A) | | A-1 | 85 | 85 | 85 | 85 | 85 |
| | | | A-2 | | | | | |
| | | | A-3 | | | | | |
| | | | A-4 | | | | | |
| | | | A-5 | | | | | |
| | | | A-6 | 15 | 15 | 15 | 15 | 15 |
| | | | A-7 | | | | | |
| | | | A-8 | | | | | |
| | Poly(methacrylic acid)-based organic particles (B) | | B-1 | | | | | |
| | | | B-2 | | | | | |
| | | | B-3 | | | | | |
| | | | B-4 | | | | | |
| | | | B-5 | | | | | |
| | | | B-6 | | | | | |
| | Particles other than poly(methacrylic acid)-based organic particles (B) | | Resin particle 1 | 15 | | | | |
| | | | Resin particle 2 | | 15 | | | |
| | | | Resin particle 3 | | | | 15 | |
| | | | Resin particle 4 | | | | | 15 |
| | Methacrylate copolymer (liquid) | | | | | 15 | | |
| | Inorganic filler (C) | | Ca-1 | | | | | |
| | | | Cb-1 | | | | | |
| | | | Ca-2 | 945 | 945 | 945 | 945 | 945 |
| | | | Cb-2 | 405 | 405 | 405 | 405 | 405 |
| | Silane coupling agent (D) | | D-1 | 0.5 | 0.5 | 0.5 | 0.5 | 0.5 |
| Property value | Viscosity [Pa·s] | | $V_{25°C}$ | 180 | 160 | 100 | 195 | 175 |
| | | | $V_{150°C}$ | 170 | 150 | 90 | 180 | 160 |
| | Viscosity ratio ($V_{150°C}/V_{25°C}$) [—] | | | 0.9 | 0.9 | 0.9 | 0.9 | 0.9 |
| | Pump-out resistance [—] | | | C | C | C | C | C |
| | Void formation [—] | | | C | C | C | C | C |
| | Coefficient of thermal conductivity [W/m·K] | | Before cooling-heating cycle test | 2.1 | 2.0 | 1.4 | 2.0 | 2.0 |
| | | | After cooling-heating cycle test | 1.8 | 1.7 | 1.0 | 1.4 | 1.5 |

| | After continuous heating at 150°C | 1.8 | 1.7 | 0.7 | 1.4 | 1.5 |
|---|---|---|---|---|---|---|
| Mass reduction rate [%] | | 0.8 | 0.8 | 1.1 | 0.8 | 0.8 |
| Thermal resistance value [°C/W] | | 4.0 | 4.2 | 5.3 | 4.3 | 4.3 |

As is clear from the results shown in Tables 2-1 to 2-3 that the grease compositions of the present disclosure each had a viscosity at 25°C of 110 to 590 Pa s, workability was good, fluidity was good, and application to a heat generation component was easy. Since interface wettability and followability were good, low thermal resistance was achieved. Due to heat generation of the heat generation component, the grease composition became the present gelled composition by being gelled and was less likely to cause pump-out. After the cooling-heating cycle test, the coefficient of thermal conductivity was improved by not less than 0.5 W/m·K.

INDUSTRIAL APPLICABILITY

As described above, the present grease composition is easily applied to a heat generation component and, after the application, even when the heat generation component reaches a high temperature such as approximately 150°C, the present grease composition can undergo gelation, and thus decrease in viscosity is suppressed and pump-out is less likely to occur. Since the present grease composition improves the coefficient of thermal conductivity by not less than 0.5 W/m·K, the present grease composition can make up for heat dissipation reduced due to deterioration of a component in long-term use, and can achieve stable performances.

Thus, the present grease composition is useful as grease used for heat transfer of heat generated from a heat generation component of an electronic device or the like, such as an IC chip, a CPU chip, a GPU chip, or an IGBT, which generates heat locally, to a heat dissipation part, such as a heat sink.

REFERENCE SIGNS

1 Heat generation body
2 Heat dissipation body
3 Grease composition
4 Substrate
5 Screw
10 Electronic component

**Claims**

1.   A grease composition comprising:

     a liquid resin (A) containing at least one type selected from the group consisting of polyols, polyethers, and diamine resins;
     poly(methacrylic acid)-based organic particles (B) dissoluble in an organic solvent having a solubility parameter (SP value) of 7.8 to 10.1; and
     an inorganic filler (C).

2.   The grease composition according to claim 1, wherein an average particle diameter of the poly(methacrylic acid)-based organic particles (B) is from 0.1 to 10.0 $\mu$m.

3.   The grease composition according to claim 1 or 2, wherein an average degree of polymerization of the poly(methacrylic acid)-based organic particles (B) is from 1000 to 50000.

4.   The grease composition according to any one of claims 1 to 3, wherein the poly(methacrylic acid)-based organic particles (B) contain at least one type selected from the group consisting of poly(alkyl methacrylate) particles, poly(alkyl methacrylic acid) ester particles, and alkyl acrylate-alkyl methacrylate resin particles.

5. The grease composition according to any one of claims 1 to 4, wherein the liquid resin (A) contains a polyether, and a proportion of the polyether in the liquid resin (A) is from 50 to 95 mass%.

6. The grease composition according to any one of claims 1 to 5, wherein the inorganic filler (C) contains an aluminum oxide particle or an aluminum nitride particle.

7. The grease composition according to any one of claims 1 to 6, wherein the grease composition is gelled by heating.

8. An electronic component comprising:

a heat generation body;
a heat dissipation body; and
the grease composition according to any one of claims 1 to 7 arranged in between the heat generation body and the heat dissipation body.

[Fig. 1]

FIG. 1

## INTERNATIONAL SEARCH REPORT

| International application No. |
| --- |
| PCT/JP2020/037230 |

**A. CLASSIFICATION OF SUBJECT MATTER**
C08L 101/00(2006.01)i; C08K 3/013(2018.01)i; C08K 3/105(2018.01)i; C08K 7/16(2006.01)i; C08L 71/00(2006.01)i; H01L 23/373(2006.01)i
FI: C08L101/00; C08K7/16; C08K3/013; C08L71/00 Z; C08K3/105; H01L23/36 M

According to International Patent Classification (IPC) or to both national classification and IPC

**B. FIELDS SEARCHED**

Minimum documentation searched (classification system followed by classification symbols)
C08L1/00-101/14; C08K3/00-13/08; H01L23/373

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2019-167429 A (TEIJIN LTD.) 03 October 2019 (2019-10-03) entire text | 1-8 |
| A | JP 2018-190911 A (NAMICS CORP.) 29 November 2018 (2018-11-29) entire text | 1-8 |
| A | JP 2017-102291 A (KYORITSU CHEMICAL & CO., LTD.) 08 June 2017 (2017-06-08) entire text | 1-8 |
| A | JP 2012-102301 A (NITTO DENKO CORP.) 31 May 2012 (2012-05-31) entire text | 1-8 |
| A | JP 2005-502776 A (AOS THERMAL COMPOUNDS) 27 January 2005 (2005-01-27) entire text | 1-8 |
| A | JP 2011-057734 A (HITACHI ELECTRIC SYSTEMS LTD.) 24 March 2011 (2011-03-24) entire text | 1-8 |

☐ Further documents are listed in the continuation of Box C.   ☒ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 27 November 2020 (27.11.2020) | 08 December 2020 (08.12.2020) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**
Information on patent family members

International application No.

PCT/JP2020/037230

| Patent Documents referred in the Report | Publication Date | Patent Family | Publication Date |
|---|---|---|---|
| JP 2019-167429 A | 03 Oct. 2019 | (Family: none) | |
| JP 2018-190911 A | 29 Nov. 2018 | (Family: none) | |
| JP 2017-102291 A | 08 Jun. 2017 | (Family: none) | |
| JP 2012-102301 A | 31 May 2012 | US 2013/0244020 A1 entire text<br>WO 2012/063935 A1<br>EP 2639259 A1<br>TW 201229116 A<br>CN 103210028 A<br>KR 10-2013-0143584 A | |
| JP 2005-502776 A | 27 Jan. 2005 | US 2002/0086801 A1 entire text<br>US 6475962 B1<br>US 2004/0018945 A1<br>WO 2003/024724 A2<br>EP 1189278 A2<br>CN 1697870 A<br>KR 10-0919798 B1 | |
| JP 2011-057734 A | 24 Mar. 2011 | (Family: none) | |

Form PCT/ISA/210 (patent family annex) (January 2015)

24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017002179 A

- JP 2019089924 A